Europäisches Patentamt

European Patent Office

Office européen des brevets

(19)

(11) Publication number: 0 155 698
A2

## (12) EUROPEAN PATENT APPLICATION

(21) Application number: 85103369.6

(22) Date of filing: 22.03.85

(51) Int. Cl.⁴: H 01 L 21/36
H 01 L 21/20

(30) Priority: 23.03.84 JP 55622/84

(43) Date of publication of application:
25.09.85 Bulletin 85/39

(84) Designated Contracting States:
DE FR GB

(71) Applicant: NEC CORPORATION
33-1, Shiba 5-chome, Minato-ku
Tokyo 108(JP)

(72) Inventor: Endo, Nobuhiro
c/o NEC Corporation 33-1, Shiba 5-chome
Minato-ku Tokyo(JP)

(72) Inventor: Kasai, Naoki
c/o NEC Corporation 33-1, Shiba 5-chome
Minato-ku Tokyo(JP)

(72) Inventor: Tajima, Masao
c/o NEC Corporation 33-1, Shiba 5-chome
Minato-ku Tokyo(JP)

(74) Representative: Glawe, Delfs, Moll & Partner
Patentanwälte
Postfach 26 01 62 Liebherrstrasse 20
D-8000 München 26(DE)

(54) A method for manufacturing a semiconductor integrated circuit device provided with an improved isolation structure.

(57) An improved isolation structure of integrated circuit devices are formed by forming grooves at a main surface of semiconductor substrate, forming an insulator film on side walls of the grooves and the main surface, the bottom of the grooves exposing the semiconductor substrate, depositing single crystal semiconductor in the grooves by selective depositing technique without depositing the single crystal semiconductor on the main surface, the grooves being substantially filled with the single crystal semiconductor, and forming circuit element in the semiconductor substrate at the main surface and/or the deposited single crystal semiconductor. The side walls of the grooves are preferably formed of crystal planes within ±8° from [100] planes of the semiconductor substrate to obtain a flat surface of the deposited single crystal semiconductor.

FIG. 2 A

FIG. 2 B

Croydon Printing Company Ltd.

FIG. 2 C

FIG. 2 D

FIG. 2 E

FIG. 2 F

0155698

— 1 —

# A METHOD FOR MANUFACTURING A SEMICONDUCTOR INTEGRATED CIRCUIT DEVICE PROVIDED WITH AN IMPROVED ISOLATION STRUCTURE

## BACKGROUND OF THE INVENTION

Field of the Invention:

This invention relates to a method for manufacturing semiconductor integrated circuit device, and more particularly to the method for producing an improved isolation structure thereof.

Description of the Prior Art:

A semiconductor integrated circuit device has a plurality of active regions, or element regions, and field regions provided between the active regions and covered with a thick oxide film to prevent undesired interaction between circuit elements. The thick oxide film is grown with an anti-oxidation mask of silicon nitride film. There is a drawback that a silicon oxide film spreads under the edge of the nitride film to form a so-called "bird's beak". Due to the bird's beak, the integrated circuit requires a wide region between circuit elements, and thus there is a limit for high integration density.

The occurrence of bird's beak is prevented by surrounding the field regions by insulating film. Such

measure has been proposed in "Japanese Journal of Applied Physics" Vol. 21, No. 1, 1982 pages 37 to 40. According to the proposition, the field region is once grooved, followed by an oxidation for forming a silicon oxide film on the surfaces of the groove and the active regions for forming the circuit elements. Polycrystalline silicon is epitaxially grown on the silicon oxide film to fill the groove. At the same time, the polycrystalline silicon is deposited on the element region with the same thickness of the polycrystalline silicon in the groove. The polycrystalline silicon on the element region is removed by reactive etching method to obtain a flat surface. The thick oxide film is then formed by oxidizing the polycrystalline silicon in the groove with a mask of silicon nitride on the element region. At this time, the spreading of the thick oxide film is prevented by the oxide film on the side of the groove.

However, this measure is not effective to increase the integration density. The groove between element regions occupies a wide area and limits the high integration density. In addition, a flat surface is obtained by the reactive etching method. This process for forming flat surface requires a precise control and causes a low production yield. Furthermore, the flat original surface is not recovered at a wide field region by the polycrystalline silicon growth. This fact compels the usage of the conventional thick oxide method at the wide field region. There is an additional drawback based on an electrically floating polycrystalline silicon which is left under the thick oxide film in the groove. This floating polycrystalline silicon causes a leakage current between elements, resulted in an unstable operation of the integrated circuit.

## SUMMARY OF THE INVENTION

It is a primary object of the present invention to provide a semiconductor integrated circuit in which circuit elements are formed with a high density and without generating an undesired interaction therebetween.

It is another object of the present invention to provide an improved isolation structure of a semiconductor integrated circuit which keeps a surface flatness without using a process requiring a precise control.

According to the present invention, there is provided a method for producing a semiconductor device which comprises the steps of forming a groove in a surface region of a semiconductor substrate, forming an insulating film on the side walls of the groove and the remaining surface region of the semiconductor substrate, the semiconductor substrate at the bottom surface of the groove being left exposed, depositting a single crystal silicon in the groove to bury it by selective epitaxial growth method, and forming circuit elements in the surface region of the semiconductor substrate and/or the single crystal silicon formed in the groove.

Preferably, the side walls of the groove are formed of (100) planes of the substrate or crystal planes within ±8° from (100) planes of the substrate.

The semiconductor device according to the present invention has the insulating film formed on the side walls of the groove, which may be used as isolation region between circuit elements. The required area for the isolation is only the thickness of the insulating film. Therefore, a large number of circuit elements can be integrated with a small area of isolation region. This achieves a very high integration density. For the formation of a thick oxide film, the insulating film operates as a stopper for spreading the oxide film. Thus, the formation of the thick oxide film is not harmful for the high integration density. The selective deposition technique can be applicable for the formation of single crystal silicon in the groove. The special process for forming a flat surface which cannot be avoided in the prior art is not necessary. This makes the process easy.

The side walls are preferably selected as near (100) planes of the semiconductor substrate. Therefore, the obtained surface of the deposited single crystal silicon is kept flat in parallel to the original surface of the semiconductor substrate. This feature makes the subsequent processes very easy and the formation of fine pattern in the subsequent processes possible. Here, if the side walls are selected as crystal planes other than near (100) planes of the semiconductor substrate, such as (110) planes, sides of the deposited silicon surface lowers than the center portion to form a so-called "facet". This facet gives a difficulty in forming a fine pattern by a photolithographic technique and lowers the dielectric withstand voltage of insulating film deposited thereon. The usage of near (100) planes as the side walls of the groove prevents the formation of such facet and obtains a flat surface of the deposited silicon. The photolithographic technique can form a fine pattern. The insulating film deposited on the deposited silicon has a high withstand voltage.

BRIEF DESCRIPTION OF THE DRAWINGS

The above and further objects, features and advantages of the present invention will become apparent from the following detailed description taken in conjunction with the accompanying drawings, wherein:

Figs. 1(a) to 1(c) are sectional views showing the prior art process for forming a semiconductor integrated device;

Figs. 2(a) to 2(f) are sectional views showing the process for forming elements regions according to a first preferred embodiment of the present invention;

Fig. 3 is a plan view of the semiconductor substrate at the process shown in Fig. 2(b);

Fig. 4(a) is a plan view of the semiconductor substrate which formed a selectively deposited silicon in grooves having side walls of (110) planes, and Fig. 4(b) is a sectional view taken along the line A-A' of Fig. 4(a); and

Figs. 5(a) to 5(f) are sectional views showing the process for forming field regions according to a second preferred embodiment of the present invention.

The prior process for producing a structure for limiting the spreading of the thick oxide film grooves first the field region of a silicon substrate 11 to form grooves 12, as shown in Fig. 1(a). Then, the surface of the substrate 11 is covered with a silicon oxide film 13 by a thermal oxidation process. Polycrystalline silicon 14 is then deposited on the whole surface of the oxide film 13. At this procedure, the narrow grooves are filled with the polycrystalline silicon 14, and the polycrystalline silicon 14 in the narrow groove becomes nearly flat with the polycrystalline silicon 14 of other portion, but the polycrystalline silicon 14 in wide groove forms a step with, the polycrystalline silicon 14 of other portion.

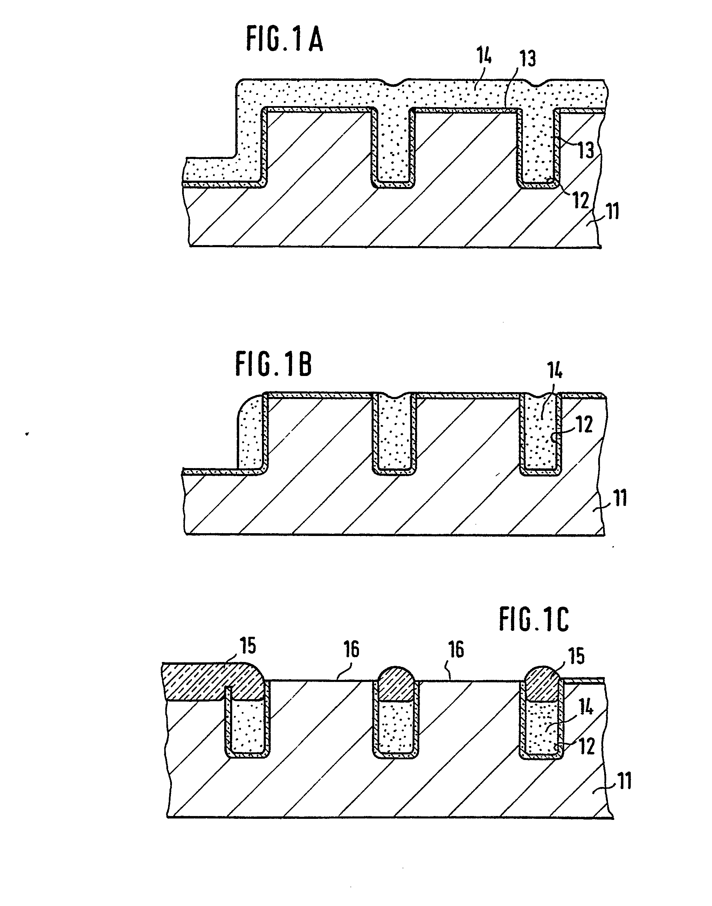

Thereafter, the polycrystalline silicon 14 is subjected to a reactive etching process to leave the polycrystalline silicon 14 in the grooves 12 only, as shown in Fig. 1(b). This reactive etching process is a process to be precisely controlled and a significant cause of a low production yield. Furthermore, the reactive etching removes the large part of the polycrystalline silicon 14 in the wide groove. That is, it is impossible to bury the wide groove with the polycrystalline silicon by this prior method.

Therefore, the prior method does not form a wide groove at the wide field region, as shown in Fig. 1(c). After the polycrystalline silicon 14 is filled in the grooves, the surface of the polycrystalline silicon 14 is oxidized to form a thick oxide film 15, and then the silicon substrate surface 16 other than groove is exposed to form circuit elements. At this procedure, the wide field region of the silicon substrate 11 is exposed and then the silicon substrate surface is oxidized to form the thick oxide film 15.

This prior art is effective to prevent the thick oxide film 15 from spreading, but is not effective to increase the integration density. The grooves 12 are necessary to isolate the circuit elements. The total area occupied by the groove is considerably large. This large area of grooves limits the high integration density. The procedure is not simple and easy. The polycrystalline silicon 14 is deposited all over the substrate surface and grooves. The reactive etching is necessary to remove the polycrystalline silicon 14 on the substrate surface and to obtain a flat surface. This process for forming a flat surface lowers the production yield, as mentioned above. Furthermore, the polycrystalline silicon 14 in the grooves under the thick oxide film 15 is electrically floating region. This electrically floating region causes a leakage current between circuit elements and applies instability to the circuit operation.

DETAILED DESCRIPTION OF THE PREFERRED EMBODIMENTS

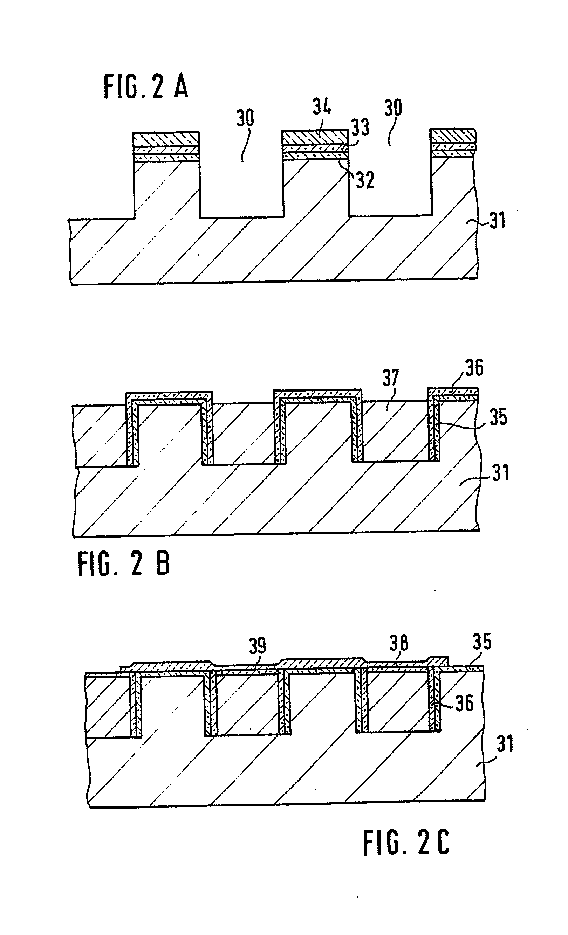

The process for forming a high density integrated circuit of a first preferred embodiment is shown in Figs. 2(a) to 2(f). A P type silicon substrate 31 having a resistivity of 0.5 to 5 ohm·cm is used. The silicon substrate 31 preferably has a surface of (100) plane and an orientation flat showing ⟨100⟩ direction. On the surface of the silicon substrate 31, a silicon oxide film 32 is thermally grown and a silicon nitride film 33 and a silicon oxide film 34 are deposited by chemical vapor deposition process. The silicon oxide film 34, the silicon nitride film 33 and the silicon oxide film 32 are selectively etched away to expose surfaces of the silicon substrate 31 by using a photolithographic technique. The exposed surfaces form a checkered pattern, for example. The exposed portions are then subjected to a reactive ion etching process to form grooves 30, as shown in Fig. 2(a). The oxide films 32 and 34 and the nitride film 33 are used as the etching mask. The grooves 30 preferably have a depth of 2 μm. The thickness of the silicon oxide film 34 is selected as a fifth to a tenth of the depth of the grooves 30. The side walls of the grooves 30 are made perpendicular to the surface of the substrate 31 by the reactive ion etching process and are formed of (100) planes or the crystal planes within ±8° from the (100) planes of the silicon substrate 31. After the formation of the grooves 30, the oxide film 32 and 34 and the nitride film 33 are removed.

The surfaces of the grooves 30 are subjected to a thermal oxidation process to form a silicon oxide film 35 of about 50 nm and then to a chemical vapor deposition process to form a silicon nitride film 36 of about 50 nm covering the whole surface. The silicon oxide film 35 and the silicon nitride film 36 at the bottom surfaces of the grooves 30 are removed by another reactive ion etching process to expose the silicon substrate 31 at the respective bottom surfaces. The damages of the silicon substrate 31 at the bottom surface of the groove 30, which are produced by the reactive ion etching, are removed by an anneal or a wet-etching, and a P type single crystal silicon 37 having the same resistivity as the silicon substrate 31 is selectively deposited in the grooves 30 with a thickness of about 2 μm to fill them, as shown in Fig. 2(b). The vapor deposition technique using chlorine vapor achives the selective deposition on the surfaces of the silicon substrate 31 without the deposition on the silicon nitride film 36. An example of the selective deposition uses gasses of $SiH_2Cl_2$ of 0.3 $l$/min, $H_2$ of 1 $l$/min and Cl of 1 $l$/min and a deposition temperature of about 950°C. The impurity may be added by flowing $B_2H_6$ gass together with the above-mentioned gasses, implanting B-ions after the selective deposition or diffusing boron into the silicon substrate 31 at the bottom surface prior to the selective deposition. The conductivity type of the deposited silicon 37 may be opposite to the substrate 31 by introducing phosphrous or arsenic. The later case is used to form complementary transistors.

After the selective deposition, a thermal oxidation film 38 of silicon oxide and a chemically deposited silicon nitride film 39 are formed on the deposited silicon 37, as shown in Fig. 2(c). The silicon nitride film 39 on portions where a thick oxide film is formed thereafter is removed, followed by a thermal oxidation process to form the thick oxide film 40 shown in Fig. 4(d). In this process, the spreading of the thick oxide film 40 is blocked by the nitride film 36 formed on the side walls of the grooves 30. The thick oxide film 40 may be formed on the limited surface portion.

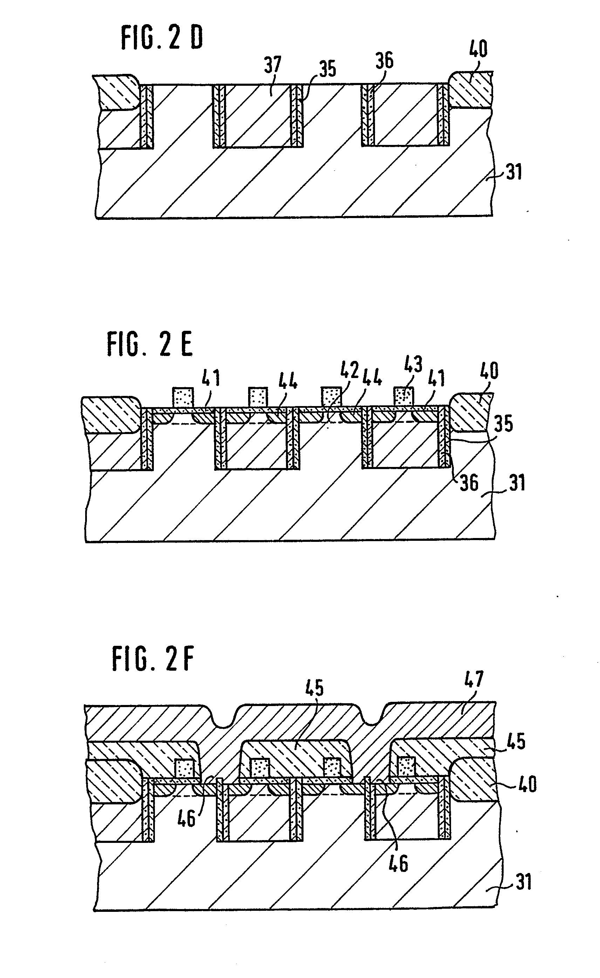

The formation of the thick oxide film 40 is performed in an oxidation atmosphere of a gas mixture of $5 \cdot H_2$ and $3 \cdot O_2$ and a temperature of 980°C for four hours to obtain a thickness of 8,000 Å. After the formation of the thick oxide film 40, the silicon oxide films 32 and 38 and the silicon nitride films 36 and 39 are removed from the surfaces of the silicon substrate 31 and the deposited silicon 37 by using hot phosphoric acid and diluted hydrofluoric acid, as shown in Fig. 2(d).

A formation of field effect transistors is followed, as shown in Fig. 2(e). The exposed surfaces of the silicon substrate 31 and the deposited silicon 37 is subjected to a thermal oxidation process to form a gate insulator film 41 of silicon oxide film having a thickness of 200 to 400 Å. A polycrystalline silicon doped with phosphorus is formed on the gate insulator film 41, and then subjected to a selective etching process to form gate electrodes 43. Source and drain regions 44 are formed by implanting arsenic ions with a dose of $5 \times 10^{15}$ cm$^{-2}$ by using the gate electrodes 43 as a mask. The implanted arsenic ions are activated by annealling, to act as N type impurities. At this procedure, if necessary, adequate impurities are implanted into the channel region 42 between the source and drain regions 44.

Finally, a silicon oxide layer 45 is deposited on the whole surface. The silicon oxide layer 45 and the gate insulator film 41 on the source and drain regions 44 are selectively etched away to form contact holes 46. Aluminium 47 is then deposited and subjected to a selective etching process to form a wiring pattern, as shown in Fig. 2(f). The ohmic connections between the aluminium 47 and the source and drain regions 44 are achieved by alloying them in high temperature circumstance.

According to the above-explained first preferred embodiment, the circuit elements are isolated by the oxide film 35 and the nitride film 36 formed on the side walls of the grooves 30 without damaging the surface flatness. The area required for the isolation is only thicknesses of the oxide film 35 and the nitride film 36. Thus, a high integration density of circuit elements is achieved. Here, the electric potential at the wiring aluminium crossing the oxide and nitride films 35 and 36 does not produce any parasitic channel between circuit elements, because the oxide and the nitride films 35 and 36 are easily formed with a deep depth and any electrically floating region does not exist between the circuit elements. Thus, a perfect isolation between circuit elements is achieved with a very small isolation area, resulted in a possibility of a very high integration density. Furthermore, if the thick oxide film 40 is formed on a region outside the circuit element regions, the oxide film 40 does not spread into the circuit element regions by the oxide and nitride films 35 and 36. Thus the formation of the thick oxide film 40 does not lower the high integration density. The process does not require any technique to be precisely controlled.

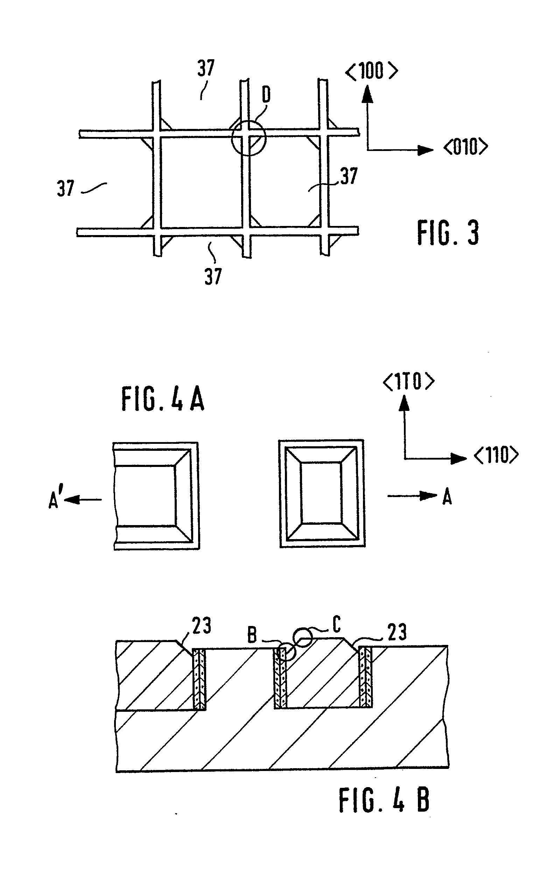

Here, the surface condition of the deposited silicon 37 will be explained in detail with reference to Figs. 3, 4(a) and 4(b). According to the first preferred embodiment, the grooves are formed so as to have side walls of (100) planes as shown in Fig. 3 or the crystal planes within ±8° from the (100) planes. The surface of the substrate 31 is selected as (100) plane.

Almost all surface grows equally to keep flatness.

If the corners "D" are rounded, only such rounded corners "D" grow slowly the single crystal silicon to form a graded surface having a crystal direction [111], [311] or [411]. This graded surface is limited to a small area. The flatness is not disturbed.

On the contrary, if the grooves are formed so as to provide side walls of [110] planes as shown in Fig. 4(a), the sides of the deposited silicon surface show a gradient as shown in Fig. 4(b) to form a so-called "facet". The gradient is a crystal direction [311] or [411] on which silicon 23 grows slowly. As a result, discontinuities appears at portions "B" and "C". If an insulating film is formed on such facet surface the insulating film shows a low withstand voltage at the portions "B" and "C". A photolighographic technique is applied to such facet surface, fine pattern cannot be formed.

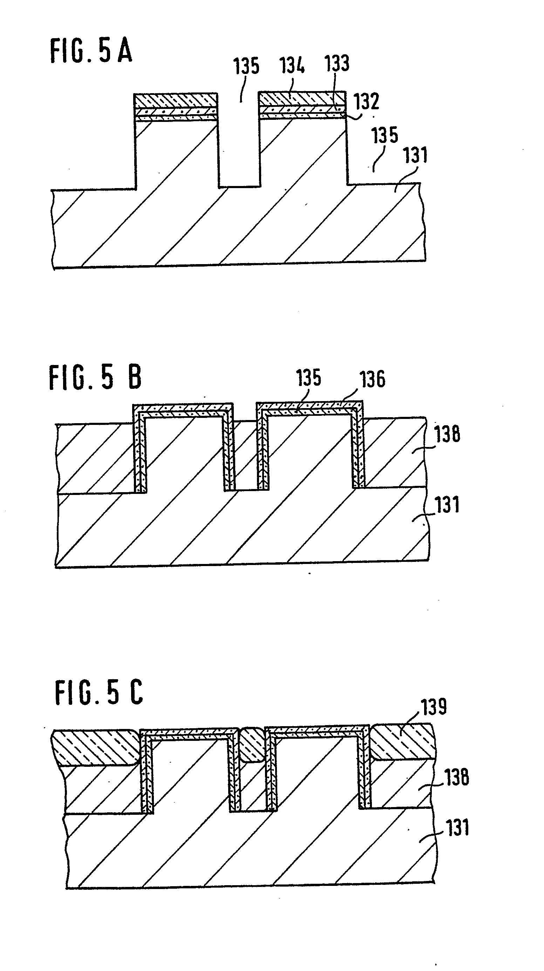

The second preferred embodiment in which the present invention is applied to the field reagion of a semiconductor integrated circuit device will be explained with reference to Figs. 5(a) to 5(f). A P type silicon substrate 131 having 0.5 to 5 ohm·cm and [100] plane is used. A silicon oxide film 132 is thermally grown on the surface of the substrate 131 followed by a chemical vapor depositions of a silicon nitride film 133 and a silicon oxide film 134. A photolithographic technique is applied to etch away the oxide films 132 and 134 and the nitride film 133 on portions of the substrate 131 at which field regions are formed in the later process. The exposed surface of the substrate 131 is subjected to a reactive ion etching process to form grooves 135 having a depth of 2 μm, as shown in Fig. 5(a). During the reactive ion etching process, the remaining oxide films 132 and 134 and nitride film 133 function as an etching mask. The side walls of the grooves 135 are formed straight by the usage of the reactive ion etching technique or other directional etching technique. Side walls of all grooves 135 is formed with (100) planes of the substrate 131. On the contrary to the prior art process, the grooves 135 are formed at not only the narrow field regions but also the wide field regions.

After the remaining oxide films 132 and 134 and nitride film 133 are removed, the whole surface of the substrate 131 is subjected to a thermal oxidation process to form a new silicon oxide film 136, followed by a chemical deposition of silicon nitride film 137. Another reactive ion etching is applied to remove the oxide film 136 and the nitride film 137 from the bottoms of the grooves 135. A single crystal silicon 138 is selectively deposited in the groves with a thickness of about 1.6 $\mu$m as shown in Fig. 5(b). The chemical vapor deposition using gasses of $SiH_2Cl_2$, $H_2$ and HCl achieves the selective deposition of silicon on crystalline silicon surface with keeping the nitride film 137 exposed. The conductivity type is applied by introducing gas including impurities into the gasses for the chemical vapor deposition of silicon. When P type is used as the substrate 131, the impurity is boron and is introduced as a form of $B_2H_6$ into the deposition gas. The resistivity of the deposited silicon 138 is made lower than the substrate to operate as a channel stopper.

The surface portions of the deposited silicon 138 are thermally oxidized to form thick oxide films 139 of 0.8 $\mu$m, as shown in Fig. 5(c). At this procedure, the spreading of the oxide film 139 is blocked by the nitride film 137 formed on the side walls of the grooves 135. Thus, the formation of the thick oxide film 139 is limited on the deposited silicon region 138. After the formation of the thick oxide films 139, the exposing oxide film 136 and nitride film 137 are removed to expose the surfaces of the substrate 131.

A gate insulator film 140 of silicon oxide is newly formed on the exposed surfaces of the substrate 131 by a thermal oxidation technique, as shown in Fig. 5(d).

Adequate ion implantation is performed to surface portion 141 of the substrate 131 to control the threshold voltages of the field effect transistors which are formed later.

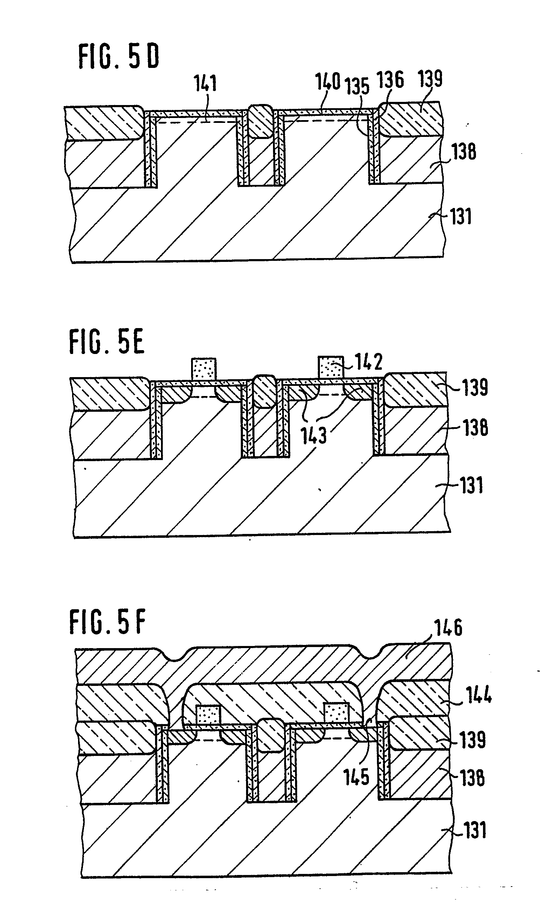

.A polycrystalline silicon doped with phosphorous is deposited on the gate insulator film 140 and then patterned as gate electrodes 142 by using a photolithographic technique. Phosphorous ions are implanted by using the gate electrodes 142 as an ion implantation mask. The implanted phosphorous ions are activated by annealing to form source and grain regions 143, as shown in Fig. 5(e).

Finally, silicon oxide film 144 is deposited to cover the whole surface. Selective portions of the silicon oxide film 144 and the gate insulator film 140 are removed to form contact holes 145. Aluminium 146 is then evaporated on the whole surface and is selectively etched away to form a wiring pattern, as shown in Fig. 5(f).

According to the second preferrred embodiment of the present invention, the selective vapor deposition can be used. This fact removes the etching process for forming a flat surface which requires a strict control and a main cause of lowering production yield. That is, the process is very easy. In addition, the crystalline silicon grows in wide grooves, similarly to in narrow grooves. All field regions are formed by same process. The surface of the deposited silicon is flat due to (100) surface side walls of the grooves 135. This flatness makes the following procedur easy.

Furthermore, the deposited silicon 138 under the thick oxide film 139 electrically contact with the substrate 131. There is no electrically floating regions. This makes the circuit operation stable. The leakage current between circuit elements is prevented by the oxide film 136 and the nitride film 137 formed on side walls of the grooves 135. Besides, it is prevented more perfectly by the usage of the low resistivity silicon as the deposited silicon 138 which functions as a channel stopper.

Although the thick oxide film 139 is formed by the thermal oxidation in the second preferred embodiment, it may alternatively formed by being deposited by RF bias sputtering technique, a combination of a chemical vapor deposition technique and a sputtering technique or a combination of a chemical vapor deposition technique and a silica painting technique.

Several preferred embodiments are explained hereinbefore. The present invention, however, is not limited to those embodiments. For example, any types of circuit elements such as bipolar transistors or junction field effect transistors may be replaced with insulated gate field effect transistors used in the embodiments. The reactive ion etching used for forming grooves may be replaced with other etching technique which perform a uniform planl etching with very little side etching, such as reactive sputter etching.

What is claimed is:

1.   A method for manufacturing a semiconductor device comprising steps of:

forming at least one groove in a semiconductor substrate at a main surface of said semiconductor substrate;

forming an insulating film on side walls of said groove, the bottom of said groove being exposed;

forming crystalline semiconductor in said groove by selective deposition technique which does not form said crystal.ine semiconductor on said main surface of said semicond·ctor substrate, said groove being substantially filled with said crystalline semiconductor; and

forming at least one circuit element on said surface of said semiconductor substrate.

2.   A method for manufacturing a semiconductor device as claimed in claim 1, wherein said side walls of said groove are crystal planes within ±8° from (100) planes of said semiconductor substrate.

3.   A method for manufacturing a semiconductor device as claimed in claim 2, wherein said main surface of said semiconductor substrate is (100) plane.

4.    A method for manufacturing a semiconductor device as claimed in claim 2, wherein said semiconductor substrate and said crystalline semiconductor are silicon.

5.    A method for manufacturing a semiconductor device as claimed in claim 3, wherein said semiconductor substrate and said crystalline semiconductor are silicon.

6.    A method for manufacturing an integrated circuit comprising steps of:

forming a plural number of grooves at main surface of a semiconductor substrate;

forming insulating films on side walls of said grooves and said main surface, the bottom of said grooves exposing said semiconductor substrate;

forming single crystal semiconductor in said groove by selective deposition technique without depositing said single crystal semiconductor on said main surface, said grooves being substantially filled with said single crystal semiconductor; and

forming a plurality of circuit element in said semiconductor substrate at said main surface and in said single crystal semiconductor in said grooves.

7.    A method for manufacturing an integrated circuit as claimed in claim 6, wherein said side walls of said

- 22 -

0155698

grooves are crystal planes within ±8° from (100) planes
of said semiconductor substrate.

8.    ·A method for manufacturing an integrated circuit
as claimed in claim 7, wherein said semiconductor
substrate is a silicon substrate having said main
surface of (100) plane, said single crystal semiconductor
being silicon.

9.    A method for manufacturing an integrated circuit
as claimed in claim 8, wherein said semiconductor
substrate and said single crystal semiconductor are
the same conductivity type.

10.    A method for manufacturing an integrated circuit
as claimed in claim 8, wherein said semiconductor
substrate and said single crystal semiconductor are
different conductivity types from each other.

11.    A method for manufacturing an integrated circuit
comprising steps of:

forming at least one groove at a main surface of
a semiconductor substrate;

forming an insulating film on side walls of said
groove and said main surface, the bottom of said groove
exposing said semiconductor substrate;

forming single crystal semiconductor in said groove by selective deposition technique without depositing said single crystal semiconductor on said main surface;

,forming a thick insulator film on said single crystal semiconductor; and

forming a circuit element in said semiconductor substrate at said main surface.

12. A method for manufacturing an integrated circuit as claimed in claim 11, wherein said side walls of said groove are crystal planes within ±8° from (100) planes of said semiconductor substrate.

13. A method for manufacturing an integrated circuit as claimed in claim 12, wherein said semiconductor substrate is a silicon substrate having a main surface of (100) plane, said single crystal semiconductor being silicon.

14. A method for manufacturing an integrated circuit as claimed in claim 12, wherein said semiconductor substrate and said single crystalline semiconductor are the same conductivity type, said single crystal semiconductor having a lower resistivity than said semiconductor substrate.

15. An integrated circuit comprising:

a semiconductor substrate having a plurality of grooves at a main surface;

an insulator film formed on side walls of said grooves, the bottoms of said grooves being not covered with said insulator film;

single crystal semiconductor regions formed in said grooves in electrically contact with said semiconductor substrate at said bottoms of said grooves; and

a plurality of circuit elements formed in said semiconductor substrate at said main surface.

16. An integrated circuit as claimed in claim 15, wherein said side walls of said grooves are formed of crystal planes within±8° from (100) planes of said semiconductor substrate.

17. An integrated circuit as claimed in claim 16, wherein the conductivity types of said semiconductor substrate and said single crystal semiconductor regions are the same, said single crystal semiconductor regions being covered with thick oxide films.

18. An integrated circuit as claimed in claim 16, wherein the conductivity, types of said semiconductor substrate and said single crystal semiconductor regions are the same, a plurality of other circuit elements being formed in said single crystal semiconductor regions.

19. An integrated circuit as claimed in claim 16, wherein the conductivity types of said semiconductor substrate and said single crystal semiconductor regions are different from each other, a plurality of other circuit elements which have different characteristics from said circuit elements being formed in said single crystal semiconductor regions.

## FIG.1A

## FIG.1B

## FIG.1C

0155698

2/6

FIG. 2 A

FIG. 2 B

FIG. 2 C

FIG. 2 D

FIG. 2 E

FIG. 2 F

FIG. 3

FIG. 4 A

FIG. 4 B

FIG. 5 A

135    134    133
                132
                135    131

FIG. 5 B

135    136
                138
                131

FIG. 5 C

139
138
131

## FIG. 5 D

141      140 135 136 139

138

131

## FIG. 5E

142

139

143

138

131

## FIG. 5 F

146

144

139

145

138

131